# EUROPÄISCHE PATENTANMELDUNG

(11) **EP 1 478 219 A2**
(43) Veröffentlichungstag der Anmeldung: **17.11.2004**
(21) Anmeldenummer: 04010247.7
(22) Anmeldetag: 30.04.2004
(51) Int. Cl.: H05K 7/20

(54) **Anordnung zum Kühlen eines Thyristors**

(30) Priorität: 14.05.2003 DE 10321549
(71) Anmelder: ADAM OPEL AG, 65423 Rüsselsheim (DE); Bosch Rexroth AG, 97813 Lohr am Main (DE)
(72) Erfinder: Klein, Dieter, 64572 Büttelborn (DE); Richter, Roland, 65375 Oestrich-Winkel (DE); Scholz, Reinhard, 64711 Erbach (DE)

(57) **Zusammenfassung**

Eine Anordnung zum Kühlen eines luftgekühlten Thyristors (10), insbesondere eines Thyristors (10) für eine Schweißanlage, umfasst einem daran thermisch gekoppelten Kühlkörper (20). Die Anordnung weist ein Gebläse (30) auf, das einen Luftstrom erzeugt, der den Kühlkörper (20) wärmeabführend überstreicht.

## Beschreibung

Die Erfindung bezieht sich auf eine Anordnung zum Kühlen eines Thyristors, insbesondere eines Thyristors für eine Schweißanlage, mit einem daran thermisch gekoppelten Kühlkörper.

Thyristoren stellen stufenlos steuerbare Gleichrichterelemente dar, die zu einem bestimmten Zeitpunkt geöffnet werden können und einen Stromfluss nur in eine Richtung erlauben. Im Zusammenhang mit Schweißanlagen werden Thyristoren zum Steuern des Schweißstroms bzw. der Schweißspannung eingesetzt. Leistungsthyristoren in Schweißanlagen werden zur Zeit luft- oder flüssigkeitsgekühlt. Flüssigkeitsgekühlte Thyristoren erfordern eine aufwendige Installation. Zur Zeit werden Anstrengungen dahin gehend unternommen, Schweißanlagen ohne Kühlflüssigkeitseinspeisung (Wassereinspeisung) zu entwickeln. Die Kühlung derzeit auf dem Markt befindlicher luftgekühlter Leistungsthyristoren ist für große Leistungen, wie sie z. B. das Widerstandsschweißen erfordert, nicht ausreichend. Thyristoren für diesen Einsatzzweck erfordern deshalb einen besonders großen Kühlkörper. Darüber hinaus müssen sie spannungsisolierend aufgebaut sein, was sich auch in einem hohen Preis dieser Thyristoren niederschlägt.

Die EP 0 582 217 B1 zeigt ein kühlflüssigkeitsgekühltes Stromrichtermodul. Bei diesem wird eine Kühlflüssigkeitsströmung zum Kühlen von Leistungsbauelementen des Stromrichtermoduls, wie Thyristoren, erzeugt. Die Kühlflüssigkeitsströmung wird dabei zusätzlich für den Antrieb eines Lüfters herangezogen, welcher zum Kühlen thermisch geringer belasteter Baukomponenten dient. Eine reine Luftkühlung ist auf Grund der erheblichen Wärmebelastungen der Leistungbauelemente nicht vorgesehen, da sie den Anforderungen nicht genügen würde.

Des Weiteren beschreibt die DE 297 17 480 U1 eine Anlage zum Kühlen von drehzahlgeregelten Antrieben, welche über Thyristorgeräte gespeiste Drehstrommotoren oder Gleichstromantriebe aufweist. Ein Regler- und Leistungselektronikteil ist dabei in einem geschlossenen Schrank untergebracht und wird in Umlaufkühlung betrieben. Eine niedrige Kühltemperatur wird durch einen Luft-/Kältemittel-Wärmetauscher erzielt, der in einem eigenen Schrank angeordnet und mit einem Luftstrom beaufschlagt ist. Der Luftstrom ist durch einen drehzahlverstellbaren Lüfter regelbar. Auch bei dieser Anlage ist demnach zum Kühlen der Antriebe eine sekundäre Flüssigkeitskühlung erforderlich.

Darüber hinaus offenbart die DE 833 45 47 U1 eine Anordnung zur Kühlung externer Beschaltungselemente eines flüssigkeitsgekühlten Thyristormoduls. Diese werden dafür wärmeleitend mit einem Kühlkörper des Thyristormoduls verbunden. Auch dieser Druckschrift lassen sich keine Anhaltspunkte für eine besonders wirksame Luftkühlung der Beschaltungselemente oder des Thyristormoduls entnehmen.

Es ist Aufgabe der Erfindung, eine Anordnung zum Kühlen eines luftgekühlten Thyristors der eingangs genannten Art bereitzustellen, welche basierend auf einem reinen Luftkühlungsprinzip eine funktionsgemäße Kühlung garantiert und die konstruktiv einfach aufgebaut, leicht wartbar sowie kostengünstig ist.

Diese Aufgabe wird bei der Anordnung erfindungsgemäß durch ein Gebläse gelöst, das einen Luftstrom erzeugt, der den Kühlkörper wärmeabführend überstreicht.

Aufgrund der konvektiven Wärmeabfuhr benötigt der Thyristor einen deutlich kleineren Kühlkörper als ein herkömmlicher luftgekühlter Thyristor, dessen Kühlkörper zum Erbringen gleicher Kühlleistung etwa dreimal so groß sein muss. Umgekehrt heißt dies aber auch, dass ein luftstromgekühlter Thyristor mit einem Kühlkörper üblicher Größe eine erheblich :höhere Leistung erbringen kann. Beispielhaft liefert ein herkömmlicher luftgekühlter Thyristor eine Stromstärke von 800 A und eine Spannung von 1200 V, während der hier beschriebene luftgekühlte Thyristor bei einem Drittel der Baugröße eine Stromstärke von 1200 A und eine Spannung von 1600 V liefert. Ein derart luftgekühlter Thyristor stellt deshalb in Schweißanlagen eine interessante Alternative zu herkömmlich gekühlten Thyristoren dar. Bei in etwa gleichen Herstellungskosten entfallen grundsätzlich die bislang notwendige Kühlflüssigkeitsinstallation und -pflege üblicherweise eingesetzter flüssigkeitsgekühlter Thyristoren, wodurch insbesondere die Wartungskosten erheblich reduziert werden. Durch seine reduzierte Baugröße ist darüber hinaus ein luftgekühlter Thyristor auch besser erreichbar und schneller austauschbar. Die Anbringung eines entsprechenden Gebläses selbst im Nachhinein ist konstruktiv einfach und technisch zuverlässig.

In Ausgestaltung der Erfindung ist der Thyristor in einem geschlossenen Gehäuse oder Schaltschrank angeordnet, aus dessen Innerem die Wärme in die äußere Umgebung geführt ist. Augrund der vorstehend beschriebenen Luftkühlung des Thyristors mittels Gebläse erfolgt im gesamten Gehäuse bzw. Schaltschrank eine Umwälzung der Luft und der Wärmeaustausch bzw. die Wärmeabgabe erfolgt über die wärmeleitenden Wände des Gehäuses oder Schaltschrankes, die in der Regel aus Metall gefertigt sind. Hierbei werden auch von anderen Geräten innerhalb des Schaltschrankes verursachte Wärmenester vermieden und die von dem Thyristor und den zusätzlichen Geräten abgegebene Wärme wird praktisch vollständig aus dem Schaltschrank entfernt, wodurch sogar niedrigere Innentemperaturen von Schaltschränken als beim Einsatz flüssigkeitsgekühlter Thyristoren erzielt werden. Des Weiteren hat dieser gebläseunterstützte Wärmeaustausch über die Wände des Schaltschrankes den Vorteil einer relativ geringen Verschmutzung des Inneren des Schaltschrankes, der keine Luftfilter aufweisen muss, da keine Frischluftzufuhr sondern lediglich eine Luftumwälzung erfolgt.

Bevorzugt leitet ein Kanal den Luftstrom nach Überstreichen des Kühlkörpers zur Wärmeabgabe an die äußere Umgebung. Dabei wird der Kühlkörper so an einer Innenwand des Schaltschranks montiert, dass keine zusätzliche (Warm-) Luftführung an dessen Außenseite erforderlich ist. Der Kanal kann derart ausgebildet bzw. angeordnet werden, dass der Luftstrom zur Wärmeabgabe direkt an eine Wand des Schaltschranks (Diese Wand dient dann als Kühlkörper, der seine Wärme an die Umgebung des Schrankes abgibt.) oder ins Freie geleitet wird. Ein Auslass des Gebläses kann dabei beispielsweise auch direkt mit einem Luftauslass des Schaltschranks verbunden sein. Dadurch fallen keine weiteren Kosten für Luftführungen, wie Schläuche Rohre oder Luftfilter, an, welche zudem wiederum zur Erwärmung des Schaltschrankes beitragen würden.

Zweckmäßigerweise bilden der Kühlkörper und das Gebläse eine Montageeinheit. Eine solche Montageeinheit ist für einen Werker oder das Wartungspersonal leicht zu handhaben, also leicht ein- oder auszubauen. Dies insbesondere dann, wenn die Montageeinheit aus Kühlkörper und Gebläse in etwa eine würfelförmige Abmessung aufweist, die - im Gegensatz zu den herkömmlich gekühlten Thyristoren - leicht zu umfassen ist.

Nach einer Weiterbildung der Erfindung ist der Thyristor von dem Kühlkörper fast vollständig umschlossen. Die wärmeabführende Kontaktfläche zum Kühlkörper ist insbesondere dann maximiert, wenn der Thyristor in den Kühlkörper eingesteckt oder eingeschoben und dann befestigt wird. Es bleibt dann nur die nach außen zeigende Fläche unkontaktiert.

Es versteht sich, dass die vorstehend genannten und nachstehend noch zu erläuternden Merkmale nicht nur in der jeweils angegebenen Kombination, sondern auch in anderen Kombinationen verwendbar sind. Der Rahmen der vorliegenden Erfindung ist nur durch die Ansprüche definiert.

Die Erfindung wird im Folgenden anhand eines Ausführungsbeispiels unter Bezugnahme auf die zugehörigen Zeichnungen näher erläutert. Gleiche oder gleichwirkende Teile sind mit gleichen Bezugsziffern versehen. Es zeigen:

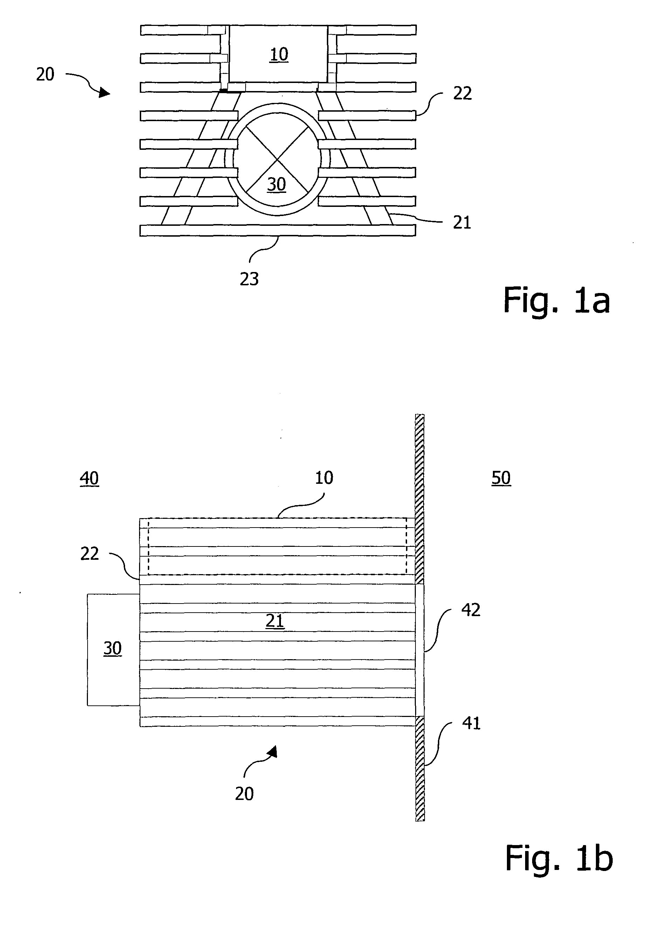

- Fig. 1a: eine schematische Vorderansicht einer erfindungsgemäßen Anordnung zum Kühlen eines luftgekühlten Thyristors, und
- Fig. 1b: eine schematische Seitenansicht der Anordnung nach Fig. 1a, montiert an einer Wand eines Schaltschranks.

Nach Fig. 1a ist ein Thyristor 10 in einen Kühlkörper 20 eingesetzt. Die an V-förmigen Stegen 21 angesetzten Kühlrippen 22 werden von einem Luftstrom überstrichen, der von einem Gebläse 30 erzeugt wird und in Richtung des Betrachters verläuft. Das Gebläse 30 ist vom Betrachter aus gesehen hinter dem Kühlkörper 20 mit dem darin gehaltenen Thyristor 10 befestigt. Die V-förmigen Stege 21 bilden dabei mit dem Thyristor 10 bzw. seiner Aufnahme und einer Bodenplatte 23 einen Kanal, in dem der Luftstrom geführt wird, so dass eine zugleich gelenkte Wärmeabfuhr gegeben ist.

Gemäß Fig. 1b ist der in einen Kühlkörper 20 eingesetzte Thyristor 10 an einer Wand 41 eines Schaltschranks 40 montiert. Zu erkennen ist in dieser Seitenansicht auch die Anbringung des Gebläses 30 an der Hinterseite des Kühlkörpers 20. Grundsätzlich kann zum Erzeugen eines Luftstroms auch ein der Leistung des Thyristors 10 angepasstes größeres oder kleineres Gebläse 30 eingesetzt werden. Der durch die V-förmigen Stege 21, die Bodenplatte 23 und den Thyristor 10 gebildete Kanal steht direkt mit einem Luftauslass 42 in der Wand 41 des Schaltschranks 40 in Verbindung. Durch den Luftauslass 42 wird die vom Thyristor erzeugte Wärme an die äußere Umgebung 50 abgeführt, wodurch nicht nur der Thyristor 10 stärker als herkömmliche Thyristoren gekühlt, sondern auch die Innentemperatur des Schaltschranks 40 stärker als bislang bekannt abgesenkt wird.

Bei in etwa gleichen Herstellungs- und deutlich geringeren Wartungskosten stellt ein in dieser Art gekühlter Thyristor für Schweißanlagen eine technisch und wirtschaftlich interessante Alternative zum Einsatz herkömmlich gekühlter Thyristoren dar.

### Bezugszeichenliste

- 10: Thyristor
- 20: Kühlkörper
- 21: Steg
- 22: Kühlrippe
- 23: Bodenplatte
- 30: Gebläse
- 40: Schaltschrank
- 41: Wand
- 42: Luftauslass
- 50: Umgebung

## Patentansprüche

1. Anordnung zum Kühlen eines luftgekühlten Thyristors (10), insbesondere eines Thyristors (10) für eine Schweißanlage, mit einem daran thermisch gekoppelten Kühlkörper (20), **gekennzeichnet durch** ein Gebläse (30), das einen Luftstrom erzeugt, der den Kühlkörper (20) wärmeabführend überstreicht.

2. Anordnung nach Anspruch 1, **dadurch gekennzeichnet, dass** der Thyristor (10) in einem geschlossenen Gehäuse oder Schaltschrank (40) angeordnet ist, aus dessen Innerem die Wärme in die äußere Umgebung geführt ist.

3. Anordnung nach Anspruch 1 oder 2, **dadurch gekennzeichnet, dass** ein Kanal den Luftstrom nach Überstreichen des Kühlkörpers (20) zur Wärmeabgabe an die äußere Umgebung (50) leitet.

4. Anordnung nach einem der Ansprüche 1 bis 3, **dadurch gekennzeichnet, dass** der Kühlkörper (20) und das Gebläse (30) eine Montageeinheit bilden.

5. Anordnung nach Anspruch 4, **dadurch gekennzeichnet, dass** die Montageeinheit aus Kühlkörper (20) und Gebläse (30) in etwa eine würfelförmige Abmessung aufweist.

6. Anordnung nach einem der Ansprüche 1 bis 5, **dadurch gekennzeichnet, dass** der Thyristor (10) von dem Kühlkörper (20) fast vollständig umschlossen ist.
